# EUROPEAN PATENT APPLICATION

(11) **EP 2 055 677 A1**
(43) Date of publication of application: **06.05.2009**
(21) Application number: 07766933.1
(22) Date of filing: 12.06.2007
(51) Int. Cl.: C01G 3/00, C01G 1/00, H01L 39/24

(54) **MANUFACTURING METHOD OF TAPE-SHAPED Re-BASE (123) SUPERCONDUCTOR**

(30) Priority: 23.08.2006 JP 2006226421
(71) Applicant: International Superconductivity Technology Center, The Juridical Foundation, Shinbashi Minato-ku Tokyo 105-0004 (JP); SWCC SHOWA CABLE SYSTEMS CO., LTD., Tokyo 105-0001 (JP)
(72) Inventor: AOKI, Yuji, Tokyo 105-0001 (JP); NAKAOKA, Koichi, 1-14-3, Shinome, Koto-ku, Tokyo 135-0062 (JP); MATSUDA, Junko, 1-14-3, Shinome, Koto-ku, Tokyo 135-0062 (JP); YOSHIZUMI, Masateru, 1-14-3, Shinome, Koto-ku, Tokyo 135-0062 (JP); NAKANISHI, Tatsuhisa, Tokyo 105-0001 (JP); IZUMI, Teruo, 1-14-3, Shinome, Koto-ku, Tokyo 135-0062 (JP); SHIOHARA, Yuh, 1-14-3, Shinome, Koto-ku, Tokyo 135-0062 (JP)
(74) Representative: Glawe, Delfs, Moll
(86) International application number: PCT/JP2007/000623
(87) International publication number: WO 2008/023454

(57) **Abstract**

This invention provides a production process of a tape-shaped superconductor which can realize high Jc and Ic values by virtue of the elimination of the cause of generation of cracks and deterioration of an electrical connectivity in crystal grain boundaries. In producing an Re-base (123) superconductor on a substrate by an MOD process, the use of a raw material solution having a Re : Ba : Cu molar ratio of 1 : X : 3, wherein X is a Ba molar ratio satisfying X < 2 (preferably 1.0 ≦ X ≦ 1.8, especially 1.3 ≦ X ≦ 1.7), can realize the production of a thick-film tape-shaped superconductor having a superconductivity of Jc = 3.20 MA/cm2 and Ic = 525 A/cm (X = 1.5).

## Description

### TECHNICAL FIELD

This invention relates to a process for producing an oxide superconductor. In particular, this invention relates to the improvement of the process for producing tape-shaped Re-type (123) superconductor by MOD process which is useful to such as a superconducting magnet, a superconducting electric power cable and an electric power device.

### BACKGROUND ART

About the oxide superconductor, because that critical temperature (Tc) exceeds the liquid nitrogen temperature, the applications for such as the superconducting magnet, the superconducting electric power cable, the electric power device and the device are expected, and the many studies are reported.

In order to apply the oxide superconductor to the above-mentioned field, it is necessary to produce a long wire which has high critical current density (Jc) and high critical current value (Ic) . On the other hand, in order to obtain a long tape, it is necessary to form the oxide superconductor onto a metallic tape from the viewpoint of strength and flexibility. Also, in order to enable use of the oxide superconductor at a practical level which is equivalent to the metallic superconductor such as Nb₃Sn or Nb₃Al, the Ic value of about 500 A/cm (at 77 K, in self-field) is required.

Further, in the oxide superconductor, because the superconducting characteristic changes by its crystal orientation, in order to improve the Jc, it is necessary to improve the in-plane orientation, and to form the oxide superconductor onto the tape-shaped substrate. For this reason, the process for forming film which makes the oxide superconductor grow epitaxially onto the substrate having high in-plane orientation is adopted.

In this case, in order to improve the Jc, it is necessary to make c-axis of the oxide superconductor orient perpendicularly to the plane of the substrate and to make its a-axis (or b-axis) orient in plane in parallel to the plane of the substrate, and it is necessary to maintain the quantum connectivity of the superconducting state well. For this reason, by forming the intermediate layer which makes the in-plane orientation degree and the direction improve onto the metallic substrate which has the high in-plane orientation, and by using the crystal lattice of this intermediate layer as the template, making the in-plane orientation degree and the direction of the crystal of the superconducting layer improve is performed. In addition, in order to improve the Ic value, it is necessary to thicken the film thickness of the oxide superconductor which is formed onto the substrate.

As the process for producing the tape-shaped Re-type oxide superconductor, that is, as the process for producing ReBa₂Cu₃O_{y} type oxide superconductor (wherein, Re shows at least more than one kind of element selected from Y, Nd, Sm, Gd, Eu, Yb, Pt or Ho. Hereinafter called Re-type (123) superconductor.), MOD process (Metal Organic Deposition Processes) is known.

This MOD process makes metal organic acid salt decompose thermally. And after coating the solution that organic impound of metallic component is dissolving uniformly onto the substrate, by heating this and then by making this decompose, the thin film is formed onto the substrate. Because this MOD process is non-vacuum process, it is possible to form the film at low cost and high speed, and because high Jc can be obtained, there is an advantage which is suitable to produce the long tape-shaped oxide superconducting wire.

In MOD process, when making the metal organic acid salt as starting material decompose thermally, the carbonate of alkali earth metal (such as Ba) is usually formed. However, in the forming of the oxide superconductor by a solid-phase reaction through this carbonate, the high temperature heat treatment of 800 °C or more is required. Further, when forming the thick film, because the nucleation for crystal growth occurs also from parts other than the interface of the substrate, it is difficult to control the crystal growth rate. Consequently, there is a problem that it is difficult to obtain the superconducting film having superior in-plane orientation, that is, high Jc.

In order to solve the above-mentioned problem in MOD process, as the process for producing Re-type (123) superconductor without going through the carbonate, recently, the process for obtaining the superconductor is conducted vigorously by using organic acid salt containing fluorine (for example, TFA salt: trifluoroacetate) as the starting material, by performing the heat treatment in a water vapor atmosphere under the control of the water vapor partial pressure, and by going through decomposition of fluoride.

In MOD process which uses this TFA salt as the starting material, by reaction between amorphous precursor containing fluorine which is obtained after calcination of the coating film and water vapor, the superconductor grows epitaxially from the interface of the substrate by forming the liquid phase caused by HF at the interface that the superconducting film grows while generating HF gas. In this case, because it is possible to control the decomposition rate of the fluoride by water vapor partial pressure in heat treatment, the crystal growth rate of the superconductor can be controlled. Consequently, it is possible to produce the superconducting film having superior in-plane orientation. Further, in this process, it is possible to make the Re-type (123) superconductor grow epitaxially from the upper surface of the substrate at comparatively low temperature.

Heretofore, in order to enable the thick film and the high speed calcination process, the mass generation of HF gas in the calcination process is prevented by using the solution which mixed the TFA salt of Y and Ba and the naphthenate of Cu as the starting materials into the organic solvent at the molar ratio of Y : Ba : Cu = 1 : 2 : 3.

As described above, when the tape-shaped oxide superconductor is produced by MOD process, thickening the film to improve the Ic value is essential for practical application. For accomplishing the forming of the thick film by MOD process when the starting material is TFA salt, there are thoughts of increasing the viscosity of the material solution containing TFA salt and of thickening the coating film. However, when the thickness of the coating film per once becomes thick, because gas yield of HF and CO₂ by decomposition in heat treatment increases, the phenomenon that the coating film is scattered in calcination occurs. Consequently, it is difficult to produce the thick film of the tape-shaped oxide superconductor having high characteristic.

In order to produce the thick film of the superconductor, there is a thought that it is possible to thicken the calcination film by repeating the steps of the coating of the material and the calcination. However, in the above-mentioned calcination heat-treatment method of conventional technology, because the temperature-increasing rate which affects the decomposition rate of the metal organic acid salt in the calcination heat-treatment is fast, the decomposition of the metal organic acid salt including TFA salt is insufficient. Consequently, there is a tendency that the solvent or the organic acid salt remains in the film of the oxide superconductor precursor which is obtained by the calcination. Therefore, at the time of temperature rising of the subsequent heat treatment for crystallization, the remaining organic acid salt such as fluoride decomposes rapidly, and the bumping evidences, the extraneous materials, the pores, etc. are generated in the film. Further, the stress is generated in the film by the volume shrinkage when the calcination film decomposes and the crystal of YBCO is formed, and the cracks that the bumping evidences, the extraneous materials, the pores, etc. become the starting point are generated.

This tendency becomes remarkable when the film of the oxide superconductor precursor of multilayer structure is formed and when thickening the film by repeating the coating and the calcination heat-treatment. Consequently, the cracks remain in the state as it is when the obtained thick film of the precursor is crystallized, and when the superconducting film is obtained. Therefore, because the current pathway is blocked when applying current, the Jc characteristic deteriorates remarkably.

In order to solve these problems, by controlling the temperature-increasing rate in the calcination heat-treatment, and then by making the metal organic acid salt recompose sufficiently, the method to accomplish the thick film and high Jc is known (for example, refer to Patent document No.1).

Besides, by controlling the calcination heat-treatment at the time of the heat treatment of the oxide superconductor precursor formed onto the substrate, and/or, by controlling the water vapor partial pressure of introduced gas in the atmosphere of the crystallization heat-treatment, the process for producing thick-film tape-shaped oxide superconductor having high orientation and high Jc is known (for example, refer to Patent document No.2).

Patent document No.1: Japanese Patent Publication No.2003-300726
Patent document No.2: Japanese Patent Publication No.2003-34527

### DISCLOSURE OF THE INVENTION

### PROBLEM TO BE SOLVED BY THE INTENTION

However, in the above-mentioned process which controls the temperature-increasing rate in the calcination heat-treatment, or, in the processes which control the calcination heat-treatment and/or the water vapor partial pressure of introduced gas in the atmosphere of the crystallization heat-treatment, although thickening the film was achieved than before, the film thickness was limited to approximately 1.0µm. And the cracks are generated when the film thickness reached approximately 1. 5µm even in the improved process of the crystallization heat-treatment. Therefore, it was difficult to obtain the thick film having high Jc and Ic values.

This invention was conducted based on the knowledge that the deterioration of Jc associated with thickening the film or the low Ic value than the prospective value are caused by not only generation of the cracks but also the deterioration of the electric connectivity. And this invention aims to provide the process for producing the thick film tape-shaped Re-type (123) superconductor having high Jc and Ic values by removing or preventing these causes of the generation of the cracks and the deterioration of the electric connectivity of the crystal grain boundary.

### MEANS FOR SOLVING THE PROBLEMS

In order to solve the above-mentioned problems, in the process for producing tape-shaped Re-type (123) superconductor of this invention, in the process for producing tape-shaped Re-type (123) superconductor by giving the calcination heat-treatment after coating the raw material solution including metal elements which compose the Re-type (123) superconductor (ReBa₂Cu₃O_{y}, wherein, Re is at least more than one kind of element selected from Y, Nd, Sm, Gd, Eu, Yb, Pr or Ho) onto the substrate, and subsequently giving the heat treatment for producing the superconductor, the raw material solution of the molar ratio of Ba of the range of X < 2 when the molar ratio of Re, Ba and Cu in above-mentioned raw material solution is Re : Ba : Cu = 1 : X : 3 is used.

In this case, in order to obtain high Jc and Ic values, it is preferable that the molar ration of Ba in the raw material solution is in the range of 1.0 ≦ X ≦ 1.8, more preferably, the molar ration of Ba in the raw material solution is in the range of 1.3 ≦ X ≦ 1.7.

### EFEECT OF THE INVENTION

In this invention, by making the molar ratio of Ba of the superconductor reduce than the standard molar ratio (Y : Ba : Cu = 1 : 2 : 3), the segregation of Ba can be prevented. Consequently, by presenting the precipitation of the impurities of Ba base in the crystal grain boundary, the generation of the cracks is prevented and the electric connectivity among the crystal grains improves, and the tape-shaped Re-type (123) superconductor which has high Jc and Ic values can be produced. Further, by forming the superconducting film by MOD process, the tape-shaped Re-type (123) superconductor which has high speed, uniform thick film and excellent superconducting characteristic can be produced easily.

### BRIEF DESCRIPTION OF THE FIGURES

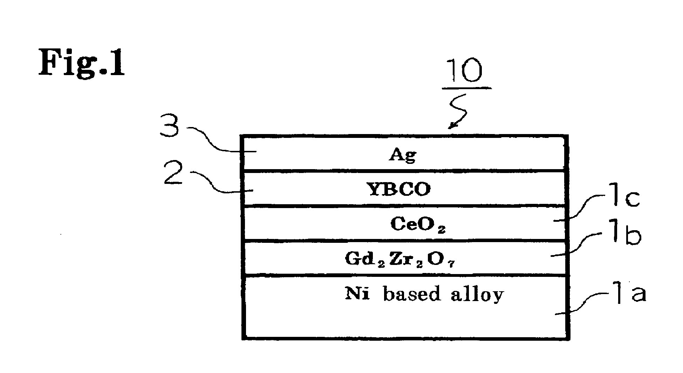

[Fig.1] The drawing which shows the cross section perpendicular to the axial direction of the tape of the tape-shaped Re-type (123) superconductor which is produced by this invention. BEST MODE FOR CARRYING OUT THE INVENTION

As described above, this invention has the feature that the molar ratio of the tape-shaped Re-type (123) superconductor, that is, the molar ratio of Ba of ReBa₂Cu₃O_{y} superconductor is reduced than the standard molar ratio.

Fig.1 shows the perpendicular cross section to the axial direction of the tape of the tape-shaped Re-type (123) superconductor which is produced by this invention. The tape-shaped Re-type (123) superconductor 10 has the cross section structure that the stabilized layer 3 comprising the Re-type (123) superconductor 2 and Ag etc. is formed on the surface of the tape-shaped substrate 1.

As the substrate 1, the biaxially-oriented substrate 1a is used. As shown in Fig.1, the composite substrate of which the high oriented intermediate layer comprising one or more layers, for example, the first intermediate layer 1b and the second intermediate layer 1c, is formed on the biaxially-oriented substrate 1a comprising such as the Ni-based alloy is preferable.

The above-described intermediate layer has the function as the buffer layer and is arranged to suppress the reaction with the superconducting layer, to prevent the deterioration of the superconducting characteristic, and to maintain the consistency with the superconducting layer.

As the above-described intermediate layer, for example, A₂Zr₂O₇ film (wherein, A is one kind of any one of Ce, Gd or Sm) which is formed by MOD process is used as the first intermediate layer, and CeO₂ film or Ce-Gd-O film which is formed by MOD process, CVD process or pulse-deposition technique is used as the second intermediate layer.

The Re-type (123) superconductor 2 is formed by MOD process. As the raw material solution, it is preferable to use the mixed solution which includes the organic solvent and any one or more kinds of trifluoroacetate, naphthenate, octylic acid salt, neodecanoic acid salt, isononanoic acid salt.

In this case, the raw material solution comprising the mixed solution of Y-TFA salt (trifluoroacetate) including the organic solvent and fluorine, Ba-TFA salt and naphthenate of Cu can be used.

As described above, from the viewpoint of improvement of the superconducting characteristic, when thickening the film, the generation of cracks becomes a problem. These applicants investigated the cause that the cracks generated when thickening the film. And these applicants filed process for producing thick-film tape-shaped Re-type (123) superconductor (application No. 2005-360788) which discharged the remained organic component or the residual fluoride in the calcination before reaching the crystallization temperature of YBCO (YBa₂Cu₃O_{Y}) by giving the intermediate heat-treatment at low temperature than the heat-treatment temperature for forming the superconductor between the calcination heat-treatment and the heat-treatment for forming the superconductor and prevented the generation of cracks.

According to the knowledge of this time, in the features of MOD process whose starting material is TFA salt, the superconductor is formed by reaction between the precursor including fluorine and the water vapor in the crystallization heat-treatment, and the crystal growth rate can be controlled by the water vapor partial pressure, and the growth rate of YBCO superconducting phase increases along with the rise of the water vapor partial pressure. However, Jc of the YBCO superconducting film decreases rapidly when exceeding the critical water vapor partial pressure by generation of cracks or formation of pores in YBCO superconducting film.

Besides, it is thought that the rough composition containing many pores which are formed after rapid decomposition and desorption of the organic component when the temperature rises in the crystallization heat-treatment becomes the starting points of the local strain and stress when the volume of the film along with the subsequent formation of YBCO phase shrinks, and this becomes the cause of the generation of the cracks.

However, as the result of the subsequent study, these applicants reasoned that the deterioration of Jc or Ic values did not originate due to only generation of cracks, and that the starting points of the local strain and stress which is the cause of the generation of cracks did not originate due to only rough composition containing many pores.

That is, among the metallic elements which constitute the Re-type (123) superconductor, depending on the condition of the calcination process, especially Ba does not disperse uniformly in the calcination film and tends to produce the segregation, and Ba becomes excess locally in the domain where this segregation occurs. Therefore, Ba impurities such as BaCeO₃ are formed in addition to the Re-type (123) superconductor. In many cases, this Ba impurities precipitate in the grain boundaries. Consequently, the impurities which are dielectric substance intervene in the grain boundaries, and the electric connectivity among the crystal grains are spoiled, in addition, it becomes one of factors which induce the generation of cracks, and as a result, it is thought that these become the cause that Jc or Ic values decrease.

Based on such a thought, in this invention, especially only molar ratio of Ba among the metallic elements which constitute the Re-type (123) superconductor is lowered than the standard molar ratio. In this invention, by lowering the molar ratio of Ba, the segregation of Ba is prevented, and the precipitation of the impurities of Ba base is prevented in the crystal grain boundary. Consequently, it is thought that the generation of cracks is prevented, the electric connectivity among the grain boundaries improves, and Jc which is defined by the conducting current improves.

Hereinafter, the embodiments of this invention are explained. Embodiments

### Embodiment 1

As the substrate, the composite substrate that the first intermediate layer comprising Gd₂Zr₂O₇ of 0.7 µm thickness and the second intermediate layer comprising CeO₂ of 0.4 µm thickness were formed in sequence onto the hastelloy tape was used. Δφ of the second intermediate layer CeO₂ in this case was 4.1° .

Meanwhile, trifluoroacetate of Y (Y-TFA), trifluoroacetate of Ba (Ba-TFA) and naphthenate of Cu were mixed so that the molar ratio of Y : Ba : Cu became 1 : 1.5 : 3, and they were dissolved into 2-octanone so that the metallic content became the concentration of 1.2 mol/liter, and thereby, the raw material solution was prepared. The viscosity of this raw material solution was 79.6 cP.

The raw material solution was coated onto the above-described substrate at the conditions of the rotation speed of 2500 rpm and the coating time of 60 sec by spin-coat method, and then the calcination heat-treatment was given. The calcination heat-treatment was given by cooling the furnace after heating till the maximum heating temperature (Tmax) of 500 °C in oxygen gas atmosphere of the water vapor partial pressure of 2.5 % at the rate of temperature increase of 2 °C/min.

After above-mentioned calcination heat-treatment, the superconducting film was formed onto the substrate by giving the heat-treatment for forming the superconductor (baking). This baking was heated till the maximum baking-temperature of 760 °C in argon gas atmosphere of the water vapor partial pressure of 13.5 % (water vapor introducing temperature: 450 °C) and the oxygen partial pressure of 0.1 % at the rate of temperature increase of 5 °C/min and held for 200 minutes at this temperature, after then, this baking was given by cooling the furnace.

The film thickness of the tape-shaped Re-type (123) superconductor which was produced by the above-mentioned process was 1.64 µm. And in the results of measured critical current density and critical current, the results of Jc = 3.20 MA/cm² and Ic = 525 A/cm were obtained.

Besides, in the measured results by X-ray diffraction about the superconducting film which was obtained by this means, the values of the peak value of (005) face of YBCO (YBa₂Cu₃O_{Y}) = 189751 cps, Δφ = 4.12 deg. , Δω = 1. 59 deg., and ∫ω = 38775 were obtained.

### Embodiment 2

The same composite substrate as Embodiment 1 was used, and trifluoroacetate of Y (Y-TFA), trifluoroacetate of Ba (Ba-TFA) and naphthenate of Cu were mixed so that the molar ratio of Y : Ba : Cu became 1 : 1.8 : 3, and they were dissolved into 2-octanone so that the metallic content became the concentration of 1.2 mol/liter, and thereby, the raw material solution was prepared. The viscosity of this raw material solution was 78.3 cP.

The raw material solution was coated onto the above-described substrate by the same method as Embodiment 1, and then the superconducting film was formed onto the substrate by giving the calcination heat-treatment and the heat-treatment for forming the superconductor (baking).

The film thickness of the tape-shaped Re-type (123) superconductor which was produced by the above-mentioned process was 1. 5 µm. And in the results of measured critical current density and critical current, the results of Jc = 2.13 MA/cm² and Ic = 320 A/cm were obtained.

Besides, in the measured results by X-ray diffraction about the superconducting film which was obtained by this means, the values of the peak value of (005) face of YBCO (YBa₂Cu₃O_{Y}) = 182099 cps, Δφ = 4.31 deg. , Δω = 1. 46 deg., and ∫ω = 38545 were obtained.

### Embodiment 3

The same composite substrate as Embodiment 1 was used, and trifluoroacetate of Y (Y-TFA), trifluoroacetate of Ba (Ba-TFA) and naphthenate of Cu were mixed so that the molar ratio of Y : Ba : Cu became 1 : 1.0 : 3, and they were dissolved into 2-octanone so that the metallic content became the concentration of 1.2 mol/liter, and thereby, the raw material solution was prepared. The viscosity of this raw material solution was 79.7 cP.

The raw material solution was coated onto the above-described substrate by the same method as Embodiment 1, and then the superconducting film was formed onto the substrate by giving the calcination heat-treatment and the heat-treatment for forming the superconductor (baking).

The film thickness of the tape-shaped Re-type (123) superconductor which was produced by the above-mentioned process was 1.61 µm. And in the results of measured critical current density and critical current, the results of Jc = 1.74 NA/cm² and Ic = 280 A/cm were obtained.

Besides, in the measured results by X-ray diffraction about the superconducting film which was obtained by this means, the values of the peak value of (005) face of YBCO (YBa₂Cu₃O_{Y}) = 181121 cps, Δφ = 4.33 deg. , Δω = 1.58 deg., and ∫ω = 37639 were obtained.

### Comparative example 1

The same composite substrate as Embodiment 1 was used, and trifluoroacetate of Y (Y-TFA), trifluoroacetate of Ba (Ba-TFA) and naphthenate of Cu were mixed so that the molar ratio of Y : Ba : Cu became 1 : 2.0 : 3 (standard composition), and they were dissolved into 2-octanone so that the metallic content became the concentration of 1.2 mol/liter, and thereby, the raw material solution was prepared. The viscosity of this raw material solution was 70.7 cP.

The raw material solution was coated onto the above-described substrate by the same method as Embodiment 1, and then the superconducting film was formed onto the substrate by giving the calcination heat-treatment and the heat-treatment for forming the superconductor (baking).

The film thickness of the tape-shaped Re-type (123) superconductor, which was produced by the above-mentioned process was 1.19 µm. And in the results of measured critical current density and critical current, the results of Jc = 2058 MA/cm² and Ic = 307 A/cm were obtained.

Besides, in the measured results by X-ray diffraction about the superconducting film which was obtained by this means, the values of the peak value of (005) face of YBCO (YBa₂Cu₃O_{Y}) = 179086 cps, Δφ = 4.12 deg. , Δω = 1. 47 deg., and ∫ω = 20902 were obtained.

### Comparative example 2

The same composite substrate as Embodiment 1 was used, and trifluoroacetate of Y (Y-TFA), trifluoroacetate of Ba (Ba-TFA) and naphthenate of Cu were mixed so that the molar ratio of Y : Ba : Cu became 1 : 2.2 : 3, and they were dissolved into 2-octanone so that the metallic content became the concentration of 1.2 mol/liter, and thereby, the raw material solution was prepared. The viscosity of this raw material solution was 70.7 cP.

The raw material solution was coated onto the above-described substrate by the same method as Embodiment 1, and then the superconducting film was formed onto the substrate by giving the calcination heat-treatment and the heat-treatment for forming the superconductor (baking) .

The film thickness of the tape-shaped Re-type (123) superconductor which was produced by the above-mentioned process was 1.63 µm. And in the results of measured critical current density and critical current, the results of Jc = 1.50 MA/cm² and Ic = 245 A/cm were obtained.

Besides, in the measured results by X-ray diffraction about the superconducting film which was obtained by this means, the values of the peak value of (005) face of YBCO (YBa₂Cu₃O_{Y}) = 158745 cps, Δφ = 4.23 deg. , Δω = 1.56 deg., and ∫ω = 37456 were obtained.

### Comparative example 3

The same composite substrate as Embodiment 1 was used, and trifluoroacetate of Y (Y-TFA), trifluoroacetate of Ba (Ba-TFA) and naphthenate of Cu were mixed so that the molar ratio of Y : Ba : Cu became 1 : 2.5 : 3, and they were dissolved into 2-octanone so that the metallic content became the concentration of 1.2 mol/liter, and thereby, the raw material solution was prepared. The viscosity of this raw material solution was 60.5 cP.

The raw material solution was coated onto the above-described substrate by the same method as Embodiment 1, and then the superconducting film was formed onto the substrate by giving the calcination heat-treatment and the heat-treatment for forming the superconductor (baking).

The film thickness of the tape-shaped Re-type (123) superconductor, which was produced by the above-mentioned process was 1.43 µm. And in the results of measured critical current density and critical current, the results of Jc = 1.01 MA/cm² and Ic = 144 A/cm were obtained.

Besides, in the measured results by X-ray diffraction about the superconducting film which was obtained by this means, the values of the peak value of (005) face of YBCO (YBa₂Cu₃O_{Y}) = 141528 cps, Δφ = 5.29 deg. , Δω = 1. 68 deg., and ∫ω = 17975 were obtained.

From the above-mentioned embodiments and comparative examples, as the raw material solution when the tape-shaped Re-type (123) superconductor is produced by MOD process, by using the raw material solution whose molar ration of Ba is the range of X < 2 or is in the range of 1.0 ≦ x ≦ 1.8 when the molar ratio of Re, Ba and Cu is Re : Ba : Cu = 1 : X : 3, the superconducting characteristic (Jc value or Ic value) which is equivalent or more as against the case of making the molar ratio of Ba into the standard molar ratio can be obtained. Especially, when the molar ratio of Ba in the raw material solution is 1.3 ≦ x ≦ 1.7, Ic value can be improved remarkably compared with the case of making the molar ratio of Ba into the standard molar ratio.

The above-mentioned result makes it reason that the property of the grain boundary gives Jc (Ic value) big influence in addition to the degree of in-plane orientation of the crystal of the superconducting layer and the degree of orientation of the crystal direction in the a-b face.

That is, when the data of embodiment 1 (Y : Ba : Cu = 1 : 1.5 : 3) and comparative example 1 (Y : Ba : Cu = 1 : 2 : 3, standard composition) is compared, Δφ and Δω are comparable level, and the degree of in-plane orientation of the crystal and the degree of orientation of the crystal direction in the a-b face do not have so much difference. However, because Jc is 3.20 MA/cm² (Ic = 525A/cm) in embodiment 1 and is 2.58 MA/cm² (Ic = 307A/cm) in comparative example 1, there is a big difference. In comparative example 1, this is considered as a result that the electric connectivity among the crystal grains deteriorates by the precipitation of the impurities and the generation of the cracks based on extra Ba in the grain boundaries of the crystal grains of the Y (123) superconductor.
Therefore, as the molar ratio of Ba becomes higher like the comparative example 2 (molar ratio of Ba = 2.2) and the comparative example 3 (molar ratio of Ba = 2.5), Jc deteriorates rapidly.

As mentioned above, according to this invention, it is possible to bring the Jc of YBCO superconducting layer close to the Jc of inside of YBCO crystal, and Ic value depending on the film thickness can be improved.

### INDUSTRIAL APPLICABILITY

It is possible to thicken the film of the superconductor by this invention, the tape-shaped Re-type (123) superconductor having high Ic value can be produced easily, and the superconducting layer is formed by MOD process which is non-vacuum process. Therefore, it is suitable to the long wire, and the production cost can be decreased remarkably.

## Claims

1. A process for producing a tape-shaped Re-type (123) superconductor by giving a calcination heat-treatment after coating raw material solution including metal elements which compose the Re-type (123) superconductor (ReBa₂Cu₃O_{Y}, wherein, Re is at least more than one kind of element selected from Y, Nd, Sm, Gd, Eu, Yb, Pr or Ho) onto a substrate, and subsequently giving a heat treatment for producing the superconductor, **characterized by** comprising the step of:
using the raw material solution of the molar ratio of Ba of the range of X < 2 when the molar ratio of Re, Ba and Cu in said raw material solution is Re : Ba : Cu = 1 : X : 3.

2. The process for producing the tape-shaped Re-type (123) superconductor according to claim 1, **characterized in that:**
the molar ratio of Ba in the raw material solution is 1.0 ≦ X ≦ 1.8.

3. The process for producing the tape-shaped Re-type (123) superconductor according to claim 1, **characterized in that:**
the molar ratio of Ba in the raw material solution is 1.3 ≦ X ≦ 1.7.

4. The process for producing the tape-shaped Re-type (123) superconductor according to any one of claims 1 to 3, **characterized in that:**
the raw material solution consists of the mixed solution of the organic solvent and any one or more kinds of trifluoroacetate, naphthenate, octylic acid salt, neodecanoic acid salt, isononanoic acid salt.

5. The process for producing the tape-shaped Re-type (123) superconductor according to claim 4, **characterized in that:**
the raw material solution consists of the mixed solution of the organic solvent and Y-TFA salt (trifluoroacetate), Ba-TFA salt including fluoride and naphthenate of Cu.

6. The process for producing the tape-shaped Re-type (123) superconductor according to any one of claims 1 to 5, **characterized in that:**
the substrate is a biaxially-oriented substrate.

7. The process for producing the tape-shaped Re-type (123) superconductor according to any one of claims 1 to 5, **characterized in that:**
the substrate is a composite substrate that a high oriented intermediate layer is formed onto the biaxially-oriented substrate.
